(19) **Europäisches Patentamt European Patent Office Office européen des brevets**

(11) **EP 4 718 026 A2**

(12) **EUROPEAN PATENT APPLICATION**

(43) Date of publication:
01.04.2026 Bulletin 2026/14

(21) Application number: 25204383.1

(22) Date of filing: 24.09.2025

(51) International Patent Classification (IPC):
*G01C 19/5712* (2012.01)

(52) Cooperative Patent Classification (CPC):
G01C 19/5712

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: 25.09.2024 IT 202400021338

(71) Applicant: STMicroelectronics International N.V.
1228 Plan-les-Ouates, Geneva (CH)

(72) Inventors:
• FEDELI, Patrick
  20030 SENAGO (MI) (IT)
• CARULLI, Paola
  20148 MILANO (IT)
• FALORNI, Luca Giuseppe
  20812 LIMBIATE (MB) (IT)
• MORELLI, Federico
  20148 MILANO (IT)

(74) Representative: Studio Torta S.p.A.
Via Viotti, 9
10121 Torino (IT)

(54) **TRIAXIAL MICROELECTROMECHANICAL GYROSCOPE WITH IMPROVED PERFORMANCES**

(57) A MEMS gyroscope is described, having a microelectromechanical structure (10) with a main extension in a horizontal plane (xy) formed by a first and a second horizontal axes (x, y) and provided with: at least one first driving mass (12,D1) that performs a translation driving movement along the second horizontal axis (y) of the horizontal plane (xy); and at least one first sensing mass (14,P1), having an anchoring element (16) arranged centrally with respect to the same first sensing mass (14,P1) and connected to the anchoring element (16) by an elastic arrangement (18); wherein the first sensing mass (14,P1) is coupled to the first driving mass (12,D1) by an elastic coupling element (20) and performs a rotation movement in the horizontal plane (xy) around the anchoring element (16), dragged by the first sensing mass (12,D1), and a sensing movement of rotation outside the horizontal plane (xy) around a rotation axis (A) defined by the elastic arrangement (18), in response to a first angular velocity around the first horizontal axis (x). The rotation axis (A) extends along the second horizontal axis (y), parallel to the translation driving movement.

FIG. 2A

**Description**

TECHNICAL FIELD

The present solution relates to a microelectromechanical gyroscope with improved performances; in particular, the following discussion will refer to a triaxial gyroscope, capable of sensing angular velocities acting along three orthogonal axes (typically denoted as roll, pitch and yaw axes).

BACKGROUND

As is known, current micromanufacturing techniques allow providing microelectromechanical systems (so-called MEMS, "Micro Electro Mechanical System") from layers of semiconductor material, which have been deposited (for example a polycrystalline silicon layer) or grown (for example an epitaxial layer) above sacrificial layers, which are removed by chemical etching.

Inertial sensors, accelerometers and gyroscopes provided with this technology are having increasing success, for example in the automotive field, in inertial navigation, or in the field of portable devices for high-end consumer electronics, for example for Optical Image Stabilization (OIS) purposes.

In particular, microelectromechanical gyroscopes made using MEMS technology from semiconductor materials (hereinafter simply referred to as MEMS gyroscopes) are known.

These MEMS gyroscopes operate on the basis of the relative acceleration theorem, exploiting the Coriolis acceleration. When a rotation at a certain angular velocity (the value of which is to be sensed) is applied to a mobile mass that is driven with a linear velocity, the mobile mass is subject to a fictitious force, called the Coriolis force, which causes it to displace in a direction perpendicular to the direction of the driving linear velocity component and also perpendicular to the axis around which the rotation occurs. The mobile mass is supported by elastic elements that allow both the driving displacement and a sensing displacement in the direction of the fictitious force. According to Hooke's law, the displacement is proportional to the fictitious force, so that, from the sensing displacement of the mobile mass, the Coriolis force and the value of the angular velocity of the rotation that generated it may be detected.

The sensing displacement of the mobile mass may for example be sensed capacitively, determining, in resonance conditions, the capacitance variations caused by the movement of mobile sensing electrodes, integral with the mobile mass (or formed by parts of the same mobile mass) and coupled (for example in a so-called "parallel-plate" configuration, or in an interdigitated configuration) to fixed or stator sensing electrodes.

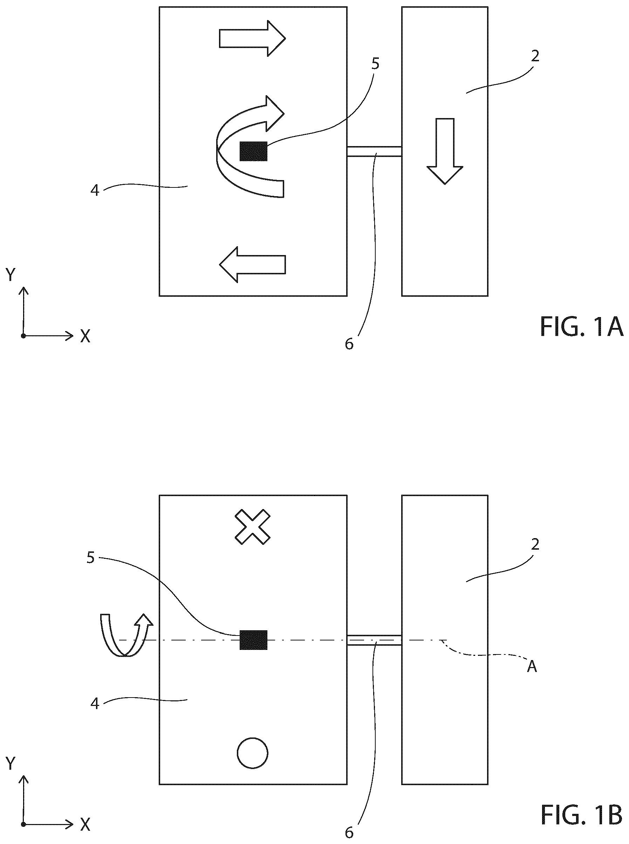

In particular, known MEMS gyroscopes generally envisage, as schematically illustrated in Figure 1A and Figure 1B, a microelectromechanical structure having at least one driving mass 2 (for example having a frame-like rectangular shape) that has a translational driving movement in a horizontal plane xy (which corresponds to a main extension plane of the same driving mass), for example along a horizontal axis y, as indicated by the arrow in Figure 1A.

At least one sensing mass 4 is coupled to this driving mass 2 and is provided with an anchoring structure 5 for anchoring to a corresponding substrate (not illustrated here), arranged centrally with respect to the same sensing mass 4.

The sensing mass 4 is rigidly coupled to the driving mass in the driving movement, so as to perform a rotation movement in the horizontal plane xy around the anchoring structure 5 (as indicated by the rotation arrow); this movement entails in particular a linear motion component along a horizontal axis x at end portions of the same sensing mass 4 (again, as indicated by the arrows in the aforementioned Figure 1A).

As shown in Figure 1B, due to the Coriolis force, the sensing mass 4 is therefore capable of carrying out a sensing movement, which corresponds to a rotation outside the horizontal plane xy, around a rotation axis A, arranged in a central position, in the example parallel to the horizontal axis x.

It has been demonstrated that this arrangement of the sensing mass 4, which rotates around a central anchor, is advantageous with respect to robustness to disturbance vibrations.

The coupling of the driving mass 2 to the sensing mass 4 is generally provided, in known solutions, by a single elastic coupling element (or "spring") 6, having a linear extension, interposed between the same driving and sensing masses 2, 4 in a central position, at the rotation axis A and lying along the same rotation axis A.

In particular, this elastic coupling element 6 couples the driving movement (of the translational type) to the sensing movement (of the rotational type), as previously described.

Although it is certainly an efficient and advantageous solution, the previously described coupling mechanism may nevertheless have some issues.

In particular, in this solution the direction of the driving movement has to be perpendicular to the rotation axis A (around which the sensing movement of rotation outside the horizontal plane xy occurs).

The design of the microelectromechanical structure of the MEMS gyroscope is therefore constrained to the presence of such relative movement between the driving and sensing masses.

Also due to the fact that the aforementioned elastic coupling mechanism significantly impacts the characteristics and performances of the gyroscope, for example in terms of area occupation, detection sensitivity and frequencies of the operating modes, it would however be advantageous to have a more flexible solution in terms of design and mutual positioning of the driving and sensing masses.

In general, a need is currently felt for a MEMS gyroscope, in particular of the triaxial type, having a reduced area occupation and reduced consumptions and that also provides improved rejection of vibrations, which represent a disturbance with respect to sensing of angular velocities of interest. Recently developed and widespread applications require in fact more demanding specifications as to the rejection of vibrations and concurrently the maintenance of sizes and performances comparable with those of known sensors, to maintain full compatibility with current consumer products.

The aforementioned MEMS gyroscopes are also required to have high performances as to the accuracy of the sensitivity value, for which it is particularly important to ensure reduced interference values between the sensing axes (so-called "cross-axis" interference).

However, currently known gyroscope structures, also due to the design constraints previously discussed, do not always allow the desired performances to be achieved.

SUMMARY

The present solution generally aims to overcome the limitations of known devices and to provide an answer to the aforementioned need.

According to the present solution, a microelectromechanical (MEMS) gyroscope, in particular of the triaxial type, is therefore provided, as defined in the attached claims.

BRIEF DESCRIPTION OF THE FIGURES

For a better understanding of the present invention, a preferred embodiment thereof is now described, purely by way of non-limiting example and with reference to the attached drawings, wherein:

- Figures 1A and 1B show a schematic plan view of a known microelectromechanical structure, with reference to a corresponding driving movement and, respectively, to a corresponding sensing movement;
- Figure 2A shows a schematic plan view of a portion of a microelectromechanical structure, in particular of a MEMS gyroscope, with reference to an elastic coupling structure between a driving mass and a sensing mass;
- Figure 2B shows an enlarged plan view of the elastic coupling structure of Figure 2A, according to an aspect of the present solution;
- Figures 2C-2E show the elastic coupling structure of Figure 2B, in different operating conditions;
- Figure 3 shows a schematic plan view of the microelectromechanical structure of a triaxial MEMS gyroscope, according to a further aspect of the present solution;
- Figure 4 schematically shows driving modes in the gyroscope of Figure 3;
- Figure 5 schematically shows a pitch sensing mode in the gyroscope of Figure 3;
- Figure 6 schematically shows a roll sensing mode in the gyroscope of Figure 3; and
- Figure 7 schematically shows a yaw sensing mode in the gyroscope of Figure 3.

DESCRIPTION OF EMBODIMENTS

As will be described below, a first aspect of the present solution provides an optimized elastic structure for the elastic coupling of a sensing mass to a corresponding driving mass in a MEMS gyroscope, in particular of the triaxial type.

This elastic structure is configured to couple the translational driving movement of the driving mass into a dragged rotation movement of the sensing mass in the horizontal plane (around a central anchor), thus allowing a sensing movement of rotation outside the same horizontal plane, in the presence of an angular velocity to be detected.

In particular, the elastic structure is configured so that the direction of the translational driving movement of the driving mass is parallel to the rotation axis around which the aforementioned sensing movement of rotation outside the horizontal plane of the sensing mass occurs.

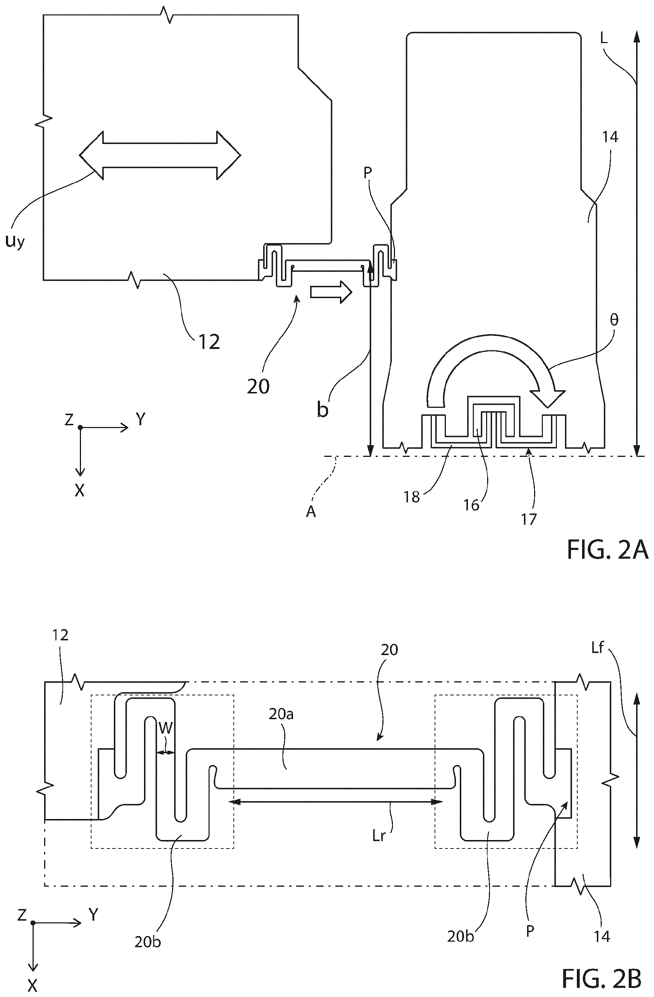

Figure 2A shows a portion of a microelectromechanical structure of a MEMS gyroscope, for example of the triaxial type, which includes at least one driving mass 12 and at least one sensing mass 14.

The sensing mass 14 (of which only a first half is shown in the aforementioned Figure 2A) has in the example a generically rectangular shape elongated along a horizontal axis x of a horizontal plane xy, which coincides with a main extension plane of the same first sensing mass 14 (which has a minor extension, substantially negligible as compared to the aforementioned main extension, along a vertical axis z, orthogonal to the horizontal plane xy).

In particular, in Figure 2A the half-length of the sensing mass 14 along the horizontal axis X is denoted with L.

The sensing mass 14 is centrally coupled to an anchoring element 16, integral with a substrate (here not illustrated), which is arranged below the same first sensing mass 14 and starting from which the microelectromechanical structure of the MEMS gyroscope is formed (this anchoring element 16 is for example formed by a vertical pillar that extends along the aforementioned vertical axis z up to reaching the underlying substrate).

In particular, the sensing mass 14 has a central window 17, having the aforementioned anchoring element 16 arranged therewithin, and is elastically connected to the same anchoring element 16 by an elastic arrangement 18, which has a main extension along the horizontal axis y of the aforementioned horizontal plane xy and defines a rotation axis A for the rotation outside the horizontal plane xy of the same sensing mass 14.

The driving mass 12 (of which only a first half is shown in the aforementioned Figure 2A) also has in the example a generically rectangular shape elongated along the horizontal axis y.

In particular, the sensing mass 14 is elastically coupled to the driving mass 12 through a coupling elastic element 20.

This coupling elastic element 20 has a generically elongated extension in the example along the horizontal axis y (i.e., parallel to the aforementioned rotation axis A) and is interposed between the sensing mass 14 and the driving mass 12, being in particular coupled to the sensing mass 14 at a coupling point P placed at a distance b from the rotation axis A, considered along the horizontal axis x, therefore the relationship 0 < b < L applies (the coupling point P may evidently correspond, for example, to a central point of an area of actual coupling between the aforementioned coupling elastic element 20 and the sensing mass 14).

In detail, as illustrated in Figure 2B, according to an embodiment of the present solution, the first coupling elastic element 20 comprises a linear elongated central portion 20a with length $L_r$, in the example along the direction of the horizontal axis y, rigid along the same direction in order to transfer the driving movement of the driving mass 12 to the sensing mass 14 (driving movement that occurs along the same direction of extension of the coupling elastic element 20, therefore parallel to the rotation axis A).

The first coupling elastic element 20 also comprises end portions 20b, arranged at the distal ends of the aforementioned central portion 20a, coupled to the driving mass 12 and, respectively, to the sensing mass 14.

These end portions 20b are elastic and yielding to movements outside the horizontal plane xy, so as to allow the rotation of the sensing mass 14 around the rotation axis A.

In particular, the presence of both end portions 20b with the above discussed elasticity features allows to achieve the desired movement of the sensing mass 14 (in the horizontal plane 14 and outside of the same horizontal plane xy), at the same time reducing the area occupation, in particular in the direction of the horizontal axis y (in general, reducing the "footprint" of the MEMS gyroscope).

On the contrary, a hypothetical coupling elastic element having only one flexible end portion (at the side of the driving mass 12 or at the side of the sensing mass 14) would entail an increase in the stiffness for the motion of the sensing mass 14, with a consequent increase in the corresponding frequency (substantially inhibiting the motion in the direction of the horizontal axis x). In order to attenuate (however, not to solve) this issue, a hypothetical coupling elastic element having only one flexible end portion should be much longer, with a high area occupation, thus not allowing to achieve the reduction of area that the present solution instead allows to achieve.

In detail, in the embodiment illustrated in Figure 2B, the end portions 20b have a folded or bellows or serpentine shape (with shorter parts extending linearly along the horizontal axis y that alternate with longer parts extending along the horizontal axis x, the latter having each time opposite directions), with an overall extension along the horizontal axis x indicated by $L_f$; the branches forming the folded pattern also have substantially a same thickness indicated by w.

As previously discussed, the configuration of the coupling elastic element 20 is such as to transfer, with a limited area occupation, the translational driving movement of the driving mass 12 into the rotation movement of the sensing mass 14 in the horizontal plane xy (around the corresponding central anchor, defined by the anchoring element 16), thus allowing its out-of-plane sensing movement due to the Coriolis force in the presence of an angular velocity (for example, of a pitch angular velocity around the horizontal axis x, as will be described in detail below).

In particular, as previously highlighted, the direction of the driving movement of the driving mass 12 is in this solution parallel to the rotation axis A around which the sensing movement of the sensing mass 14 occurs.

Furthermore, the configuration of the aforementioned coupling elastic element 20 is such as to easily allow adjusting the sensitivity value in sensing the angular velocity, simply by appropriately adjusting the distance b from the rotation axis A of the coupling point P with the sensing mass 14.

In fact, the following relationship applies, that defines the transmission of motion between the driving mass 12 (translation movement) and the sensing mass 14 (rotation movement):

$$u_y \cong \theta \cdot b$$

where $u_y$ indicates the displacement of the driving mass 12, in the example along the horizontal axis y due to the aforementioned translation movement, and $\theta$ indicates the rotation angle of the rotation movement in the horizontal plane xy performed by the sensing mass 14, around the anchoring element 16.

Furthermore, it is easy to adjust the value of the resonance frequency of the sensing mode by acting on the stiffness of the coupling elastic element 20, without significantly impacting the driving mode.

In particular, the stiffness of the coupling mechanism may be adjusted by acting on the values of overall extension $L_f$ and thickness w associated with the end portions 20b of the coupling elastic element 20 and also on the value of the length $L_r$ of the central portion 20a of the same coupling elastic element 20.

For example, a 10% modification in the aforementioned thickness w may entail a variation of about 5% in the resonance frequency associated with the sensing movement and a variation lower than 1% in the resonance frequency associated with the driving movement.

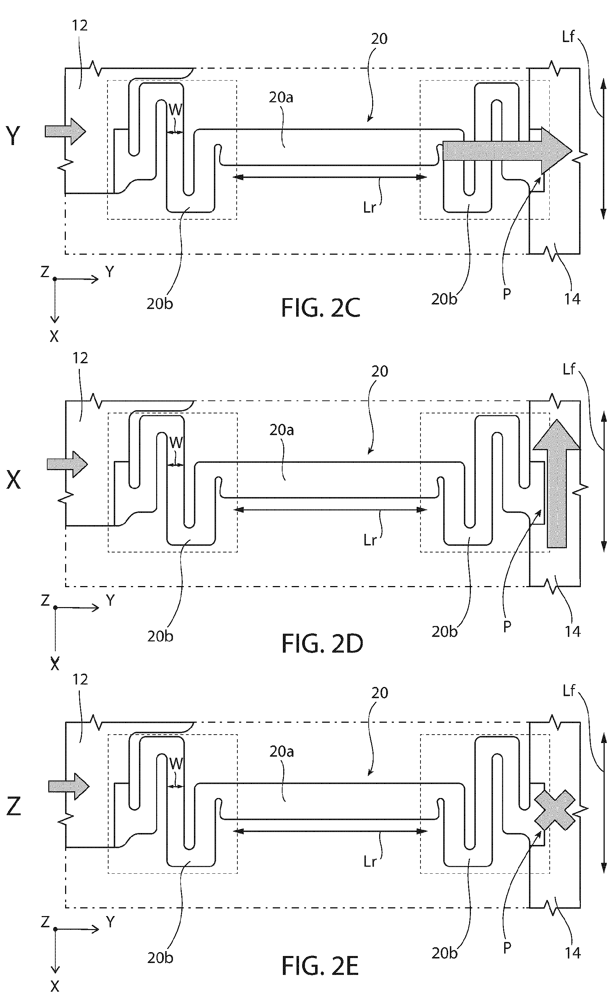

With reference to what has been discussed, Figure 2C shows the coupling elastic element 20 in the transmission of the driving movement from the driving mass 12 to the sensing mass 14, in the example along the horizontal axis y.

In this mode, the coupling elastic element 20 has a first stiffness, with a high value (for example, having a normalized value comprised between 50 e 100), so as to implement the desired transmission of the driving movement.

Figure 2D shows schematically the coupling elastic element 20 with respect to the movement in the direction of the horizontal axis x.

In this mode, the coupling elastic element 20 has a second stiffness, with a very low value, much lower than the first stiffness (for example, having a normalized value substantially equal to one), so as to implement the desired coupling between the driving (linear) movement and the sensing (rotational) movement.

Figure 2E shows schematically the coupling elastic element 20 with respect to the movement in the direction of the vertical axis z.

In this mode, the coupling elastic element 20 has a third stiffness, again with a very low value, comparable to the second stiffness, for example equal or slightly higher than the second stiffness (for example, having a normalized value comprised between one and four), so as to define the desired frequency of the motion of the sensing mass 14 out of the horizontal plane xy.

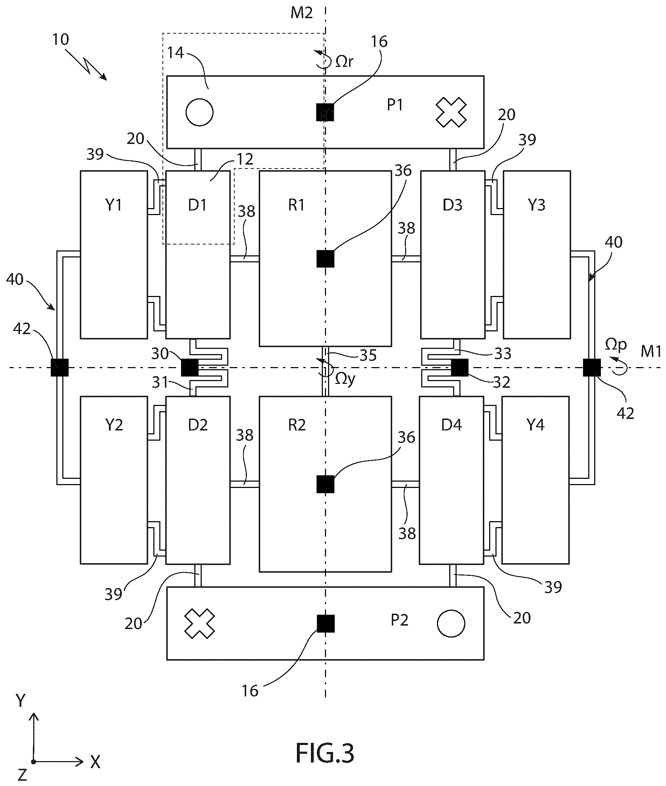

With reference to Figure 3, a possible embodiment of the microelectromechanical structure, here indicated by 10, of a triaxial MEMS gyroscope is now fully described, in accordance with a further aspect of the present solution, which comprises, inter alia, the aforementioned driving mass 12 and the aforementioned sensing mass 14 (in this Figure 3 a portion corresponding to the structure described with reference to Figure 2 is highlighted in a dashed box).

As will be described in detail, this embodiment advantageously allows, with a reduced area occupation, reducing interferences between the sensing axes and also obtaining high performances in terms of the rejection of disturbance vibrations.

The microelectromechanical structure 10 has a main extension in the horizontal plane xy (in a manner not illustrated, being suspended above a substrate at a certain separation distance along the vertical axis z) and a first and a second axes of symmetry (or median axes) M1, M2, extending respectively along the horizontal axis x and along the horizontal axis y.

The microelectromechanical structure 10, in addition to the aforementioned driving mass 12, which here represents a first driving mass indicated by D1, also comprises a second driving mass D2, to form a first pair of driving masses D1, D2, arranged on a same side of the second axis of symmetry M2, aligned along the horizontal axis y.

The driving masses of the first pair D1,D2 are also coupled, in the illustrated embodiment, to a same first driving anchor 30, integral with the substrate (in a manner not illustrated), arranged centrally at the first axis of symmetry M1, by a respective anchoring elastic element 31, of the folded or bellows type.

The microelectromechanical structure 10 also comprises a third and a fourth driving mass, indicated by D3 and D4, which form a second pair of driving masses.

The driving masses of the second pair D3,D4 are arranged on a second side of the second axis of symmetry M2, aligned along the horizontal axis y, in a manner symmetrical to the driving masses of the first pair D1,D2 with respect to the same second axis of symmetry M2.

The driving masses of the second pair D3,D4 are in this case coupled to a same second driving anchor 32, integral with the substrate (in a manner not illustrated), arranged centrally at the first axis of symmetry M1, by a respective anchoring elastic element 33, of the folded or bellows type (again in an entirely symmetrical manner with respect to the driving masses of the first pair D1, D2).

In a manner not illustrated in detail herein, the driving masses of the first and the second pairs D1,D2, D3,D4 may internally define windows for mobile driving electrodes, integral with the same masses and interdigitated with corresponding fixed driving electrodes, also arranged within the same windows; in a known manner, the interaction between the interdigitated electrodes determines the aforementioned driving movement.

The microelectromechanical structure 10 of the MEMS gyroscope also comprises, in addition to the aforementioned sensing mass 14, which here is configured to sense a pitch angular velocity and is therefore referred to as a first pitch sensing mass P1, a second pitch sensing mass P2, to form a pair of pitch sensing masses P1,P2.

In particular, the pitch sensing masses P1,P2 are arranged in a symmetrical manner with respect to the first axis of symmetry M1, externally with respect to the driving masses D1,D2, D3,D4 (along the direction of the horizontal axis y) and extend in length along the horizontal axis x traversing the second axis of symmetry M2, symmetrically with respect to the same second axis of symmetry M2.

The first pitch sensing mass P1 is elastically coupled to both the first driving mass D1 and the third driving mass D3 (i.e. to the driving masses arranged on a same side with respect to the first axis of symmetry M1) through a respective coupling elastic element 20, configured and operating in a manner entirely similar to what has been previously described.

Similarly, the second pitch sensing mass P2 is elastically coupled to both the second driving mass D2 and the fourth driving mass D4 through a respective coupling elastic element 20, again configured and operating in a manner entirely similar to what has been previously described.

The microelectromechanical structure 10 further comprises a first and a second roll sensing mass R1, R2, arranged symmetrically to each other on opposite sides of the first axis of symmetry M1 and elastically connected to each other by a coupling elastic element 35, arranged centrally at the second axis of symmetry M2 and having a stiffness such as to allow the motion of the roll sensing masses R1, R2 (as will be described in detail below) and, at the same time, such as to keep them constrained to each other in their movement.

The roll sensing masses R1, R2 are generally arranged in a central position internally to the driving masses of the first and the second pairs D1,D2, D3,D4.

Each roll sensing mass R1, R2 has a substantially rectangular shape in the horizontal plane xy, in the example elongated along the horizontal axis y and centrally has a window (not illustrated here for reasons of simplicity of depiction) having a respective roll anchor 36 arranged therewithin, to which it is coupled by an elastic coupling arrangement (not shown for simplicity of illustration) that defines a rotation axis (extending in the example along the horizontal axis x) for the sensing movement outside the horizontal plane xy.

This elastic coupling arrangement may for example be provided as described in detail in patent application 102024000017707 filed in the name of the same Applicant on July, 30, 2024.

Furthermore, the first roll sensing mass R1 is elastically coupled to the first and third driving masses D1, D3, by respective elastic coupling elements 38, which extend from opposite sides of the same first roll sensing mass R1, aligned along the horizontal axis x. As schematically shown in Figure 3, such elastic coupling elements 38 may for example be of a linear type.

Similarly, the second roll sensing mass R2 is elastically coupled to the second and fourth driving masses D2, D4, by respective elastic coupling elements 38, which extend from opposite sides of the same second roll sensing mass R2 generally along the horizontal axis x (being for example of a linear type).

Below the roll sensing masses R1,R2 (in a manner not illustrated here) respective fixed or stator electrodes are arranged, capacitively coupled to the respective roll sensing masses R1,R2 and placed above the substrate (so as to provide a differential sensing scheme, of a known type, not described in detail herein).

The microelectromechanical structure 10 of the MEMS gyroscope also comprises a first pair of yaw sensing masses Y1,Y2 and a second pair of yaw sensing masses Y3, Y4, each having a substantially rectangular shape in the horizontal plane, in the example elongated along the horizontal axis y.

Each yaw sensing mass of the first pair Y1,Y2 is elastically coupled to a respective driving mass of the first pair of driving masses D1,D2 by respective coupling elastic elements 39 (in the example, in a number equal to two for each mass, interposed between end portions of the coupled driving and yaw sensing masses).

Similarly, each yaw sensing mass of the second pair Y3,Y4 is elastically coupled to a respective driving mass of the second pair of driving masses D3,D4 by respective coupling elastic elements 39.

Furthermore, the yaw sensing masses of the first pair Y1,Y2, and the yaw sensing masses of the second pair Y3,Y4, are respectively coupled to each other by respective elastic coupling structures 40, which extend centrally along the horizontal axis y, traversing the first axis of symmetry M1.

In detail, each elastic coupling structure 40 defines a lever elastic element, of the central fulcrum type, hinged to the substrate by a central anchor 42 and coupled at its ends to the respective yaw sensing masses that form the first or the second pair.

In a manner not illustrated for reasons of simplicity of representation, the aforementioned yaw sensing masses Y1,Y2, Y3, Y4 have internally windows for yaw mobile sensing electrodes, integral with the same masses and alternating with corresponding yaw fixed or stator sensing electrodes, to define a differential sensing scheme.

Operation of the microelectromechanical structure 10 of the MEMS gyroscope is now described, for sensing a pitch angular velocity $\Omega_p$ around the horizontal axis x, a roll angular velocity $\Omega_r$ around the horizontal axis y and a yaw angular velocity $\Omega_y$ around the vertical axis z.

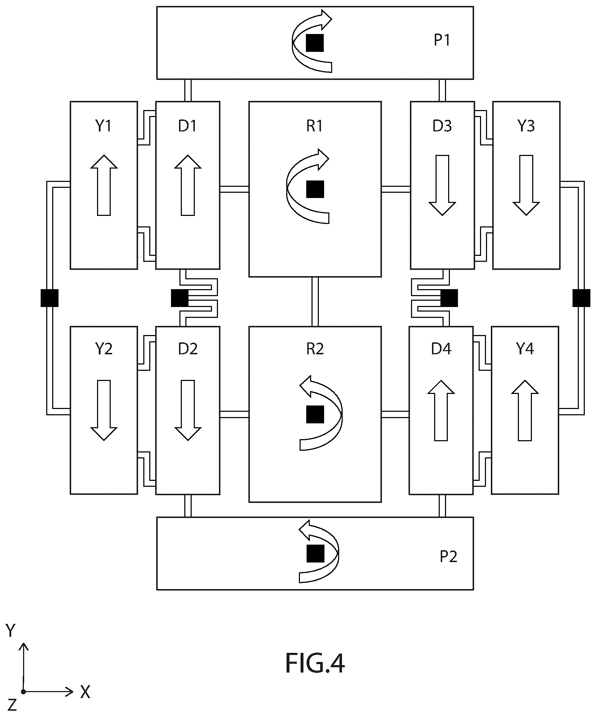

As schematically shown in Figure 4, the driving movement envisages that the driving masses D1,D2, D3,D4 are driven (by the appropriate biasing of the mobile driving electrodes and the corresponding fixed driving electrodes) to perform a translation movement (in phase-opposition for each pair) along the horizontal axis y. Furthermore, the movement of the driving masses of each pair symmetrical to each other with respect to the first axis of symmetry M1 (i.e. of the driving masses D1, D3 and D2, D4), is also in phase-opposition.

As highlighted by the arrows in the aforementioned Figure 4, the movement of the driving masses D1,D2, D3,D4 causes, due to the elastic couplings previously described, corresponding movements of the sensing masses.

In particular, the roll sensing masses R1, R2 are dragged into a rotation in phase-opposition in the horizontal plane xy, around an axis parallel to the vertical axis z and passing through the center of the respective roll anchor 36.

Furthermore, the yaw masses Y1,Y2, Y3,Y4 are dragged by the associated driving masses D1,D2, D3,D4 in an integral manner in the same translation movement in phase-opposition along the second horizontal axis y.

The movement of the driving masses D1,D2, D3,D4 also causes, due to the coupling elastic elements 20 (which operate as previously described in detail), a rotation in phase-opposition of the pitch sensing masses P1, P2, around an axis parallel to the vertical axis z and passing through the center of the respective anchoring element 16.

The aforementioned driving movements therefore occur entirely in the horizontal plane xy and do not involve further elements of the microelectromechanical structure 10 of the MEMS gyroscope.

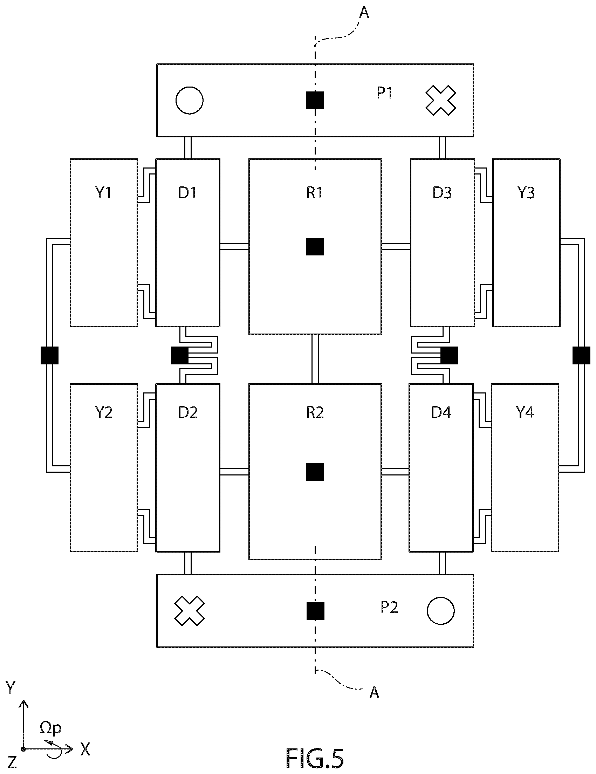

As schematically shown in Figure 5 (corresponding to a given operating instant), in the presence of a pitch angular velocity $\Omega_p$ around the horizontal axis x, the motion of the microelectromechanical structure 10 envisages a rotation of the pitch sensing masses P1,P2 in phase-opposition outside the horizontal plane xy, around the rotation axis A, parallel to the horizontal axis y and defined by the respective elastic arrangement 18 (shown in Figure 2A).

In essence, as schematically represented in Figure 5, the pitch sensing masses P1,P2 perform, due to the Coriolis force, rotation movements outside the horizontal plane xy, in phase-opposition with each other, determining, along the vertical axis z, a movement away from/towards the respective pitch stator electrodes (not illustrated here), and, overall, a capacitive variation that may be detected by a differential sensing scheme.

It is underlined that the other elements of the microelectromechanical structure 10 of the MEMS gyroscope (in particular the masses and the associated elastic elements for sensing the roll and yaw angular velocities) are not substantially involved in this operating condition or in any case do not interfere with the operating mode of detection of the pitch angular velocity.

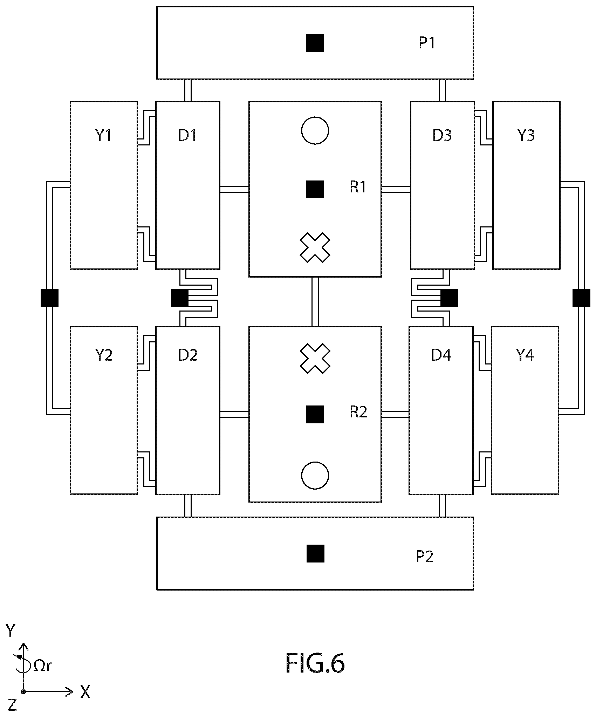

As schematically shown in Figure 6 (corresponding to a given operating instant), in the presence of a roll angular velocity $\Omega_r$ around the horizontal axis y, the motion of the microelectromechanical structure 10 envisages a rotation in phase-opposition outside the horizontal plane xy of the roll sensing masses R1,R2 around the rotation axis defined by the corresponding elastic coupling elements (that again be detected by a differential sensing scheme and respective sensing electrodes, not illustrated here).

Also in this case, the other elements of the microelectromechanical structure 10 (in particular those used to sense the pitch and yaw angular velocities) are not substantially stressed in this operating condition or in any case do not interfere with the roll sensing movement.

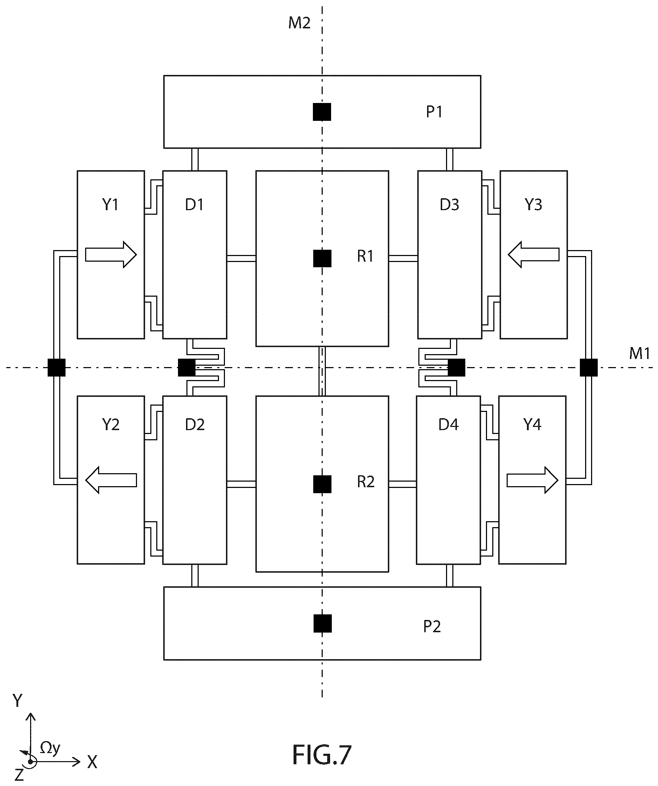

As schematically shown in Figure 7, in the presence of a yaw angular velocity $\Omega_Y$ around the vertical axis z, the sensing motion of the microelectromechanical structure 10 of the MEMS gyroscope envisages a displacement in phase-opposition of the yaw sensing masses Y1,Y2, Y3,Y4 of each pair along the horizontal axis x (as indicated by the arrows). Furthermore, the movement of the yaw sensing masses of each pair symmetrical to each other with respect to the second axis of symmetry M2 (i.e. of the yaw sensing masses Y1, Y3 and Y2, Y4), is also in phase-opposition.

This movement also entails rotation in the horizontal plane xy around the respective central anchor 42 of the lever elastic elements of the elastic coupling structures 40 that couple to each other the yaw sensing masses symmetrical with respect to the horizontal axis x.

A movement of yaw mobile electrodes (not illustrated here) along the horizontal axis x, with respect to alternating yaw stator electrodes, and a consequent capacitive variation that may be sensed by the differential scheme thus occur.

Again, the other elements of the microelectromechanical structure 10 (in particular those used to sense the pitch and roll angular velocities) remain substantially stationary in this operating condition or in any case do not interfere with sensing of the yaw movement.

Advantageously, the sensing movements of the yaw, roll and pitch sensing masses are therefore entirely independent of each other and do not have any mutual influences, effectively making the interference between the sensing axes of the MEMS gyroscope (so-called cross-axis interference) substantially zero or in any case negligible.

In particular, the driving masses D1-D4 substantially operate as decoupling elements between the various sensing masses, which are in fact all connected to the sole driving masses D1-D4, essentially without mutual connections (and interferences), and are driven by the same driving masses D1-D4 with a single driving mode.

Furthermore, the adopted differential sensing scheme allows the effects related to both linear and angular disturbance vibrations to be eliminated.

In particular, all the operating modes (i.e., the driving modes and the sensing modes) are not excitable by linear or rotational accelerations; furthermore, no spurious mode within a wide frequency range (e.g. up to 40 kHz) may be excited by a linear acceleration.

In this regard, reference may also be made to patent application EP 24177019.7 of 5/21/2024 in the name of the same Applicant, which describes a differential sensing scheme for a triaxial gyroscope that has substantially the same disturbance insensitivity features using a same movement scheme for the driving masses and for the sensing masses.

The advantages of the proposed solution are clear from the preceding description.

In any case, it is again underlined that the described solution provides an optimized elastic coupling element for MEMS gyroscopes, which allows converting translational to rotational motion, with the following features:

- the direction of the movement of the driving mass is parallel to the rotation axis around which the sensing movement (of the sensing mass associated with the same driving mass) occurs;
- the sensitivity may be modified by simply shifting the coupling point between driving and sensing masses; and
- the frequency of the sensing mode may be easily adjusted by acting on geometric features of the elastic coupling element, with a limited effect on the driving mode.

Furthermore, the described solution allows providing a triaxial gyroscope, wherein:

- a single driving mode (at a single frequency) is used, since all sensing masses are directly coupled to the same driving masses (not being coupled to each other);
- the interferences between the sensing axes are substantially zero, since the sensing movement associated with each sensing axis is completely independent of the other sensing axes;
- both interference linear vibrations and interference angular vibrations are rejected in a substantially complete manner.

As a consequence of the above features, the coupling solution allows a higher sensing accuracy to be obtained and, consequently, allows more efficient and quicker calibration operations.

Furthermore, the triaxial gyroscope has a compact architecture and does not require any substantial modification to the manufacturing process, in particular without requiring additional processing steps or different treatments with respect to standard solutions.

Finally, it is clear that modifications and variations may be made to what has been described and illustrated herein without thereby departing from the scope of the present invention, as defined in the attached claims.

In particular, the elastic coupling solution previously described, for transferring the translation motion of a driving mass to the rotation motion of the associated sensing mass, might also find advantageous application in sensing structures of uniaxial or biaxial MEMS gyroscopes.

**Claims**

1. A MEMS gyroscope comprising a microelectromechanical structure (10) having a main extension in a horizontal plane (xy) formed by a first and a second horizontal axes (x, y) and provided with: at least one first driving mass (12,D1) configured to perform a translation driving movement along the second horizontal axis (y) of the horizontal plane (xy); and at least one first sensing mass (14,P1), having an anchoring element (16), arranged centrally with respect to the same first sensing mass (14,P1), and connected to said anchoring element (16) by an elastic arrangement (18); wherein said first sensing mass (14,P1) is coupled to the first driving mass (12,D1) by an elastic coupling element (20) and is configured to perform a rotation movement in said horizontal plane (xy) around the anchoring element (16), dragged by said first sensing mass (12,D1), and a sensing movement, of rotation outside said horizontal plane (xy) around a rotation axis (A) defined by said elastic arrangement (18), in response to a first angular velocity around the first horizontal axis (x),
**characterized in that** said rotation axis (A) extends along said second horizontal axis (y), parallel to said translation driving movement of the first driving mass (12,D1).

2. The gyroscope according to claim 1, wherein said elastic coupling element (20) comprises: a central portion (20a) linear along the direction of the second horizontal axis (y), rigid so as to transfer the driving movement of the first driving mass (12,D1) to the first sensing mass (14,P1); and end portions (20b), arranged at distal ends of the central portion (20a), respectively coupled to the first driving mass (12) and to the first sensing mass (14); wherein said end portions (20b) are elastic and yielding to allow rotation outside the horizontal plane (xy) of the first sensing mass (14,P1).

3. The gyroscope according to claim 2, wherein said first sensing mass (14,P1) has an extension along said first horizontal axis (x), symmetrical with respect to said rotation axis (A); and wherein said coupling elastic element (20) is coupled to said first sensing mass (14,P1) at a coupling point (P) arranged at a distance (b), that is non-zero, from said rotation axis (A) along said first horizontal axis (x).

4. The gyroscope according to claim 2 or 3, wherein said central portion (20a) of said coupling elastic element (20) has a length ($L_r$) along said second horizontal axis (y) and said end portions (20b) of said coupling elastic element (20) have a folded shape, with an overall extension ($L_f$) along the first horizontal axis (x) and with a thickness (w) of the branches forming the folded shape; wherein the value of said distance (b) determines a detection sensitivity of said first sensing mass (14,P1) and the value of said length ($L_r$) of the central portion (20a) and of said overall extension ($L_f$) and of said thickness (w) of the end portions (20b) determines a frequency of said sensing movement.

5. The gyroscope according to any of the preceding claims, wherein said first sensing mass (14,P1) has a central window (17), within which said anchoring element (16) is arranged, in a central position; said elastic arrangement (18) being also arranged in the window (17), having a main extension along said second horizontal axis (y) and defining said rotation axis (A).

6. The gyroscope according to any of the preceding claims, wherein said microelectromechanical structure (10) has a first and a second axes of symmetry (M1, M2), extending respectively along the first horizontal axis (x) and along the second horizontal axis (y) and comprises:

in addition to said first driving mass (12,D1), a second driving mass (D2), to form a first pair of driving masses, arranged on a same side of the second axis of symmetry (M2), aligned along the second horizontal axis (y); and also a third and a fourth driving masses (D3, D4), that form a second pair of driving masses, arranged in a symmetrical manner to the driving masses of the first pair (D1,D2) with respect to the second axis of symmetry (M2) and aligned along the second horizontal axis (y);

in addition to said first sensing mass (14,P1), that represents a first pitch sensing mass (P1) for sensing a pitch angular velocity ($\Omega_P$) around the first horizontal axis (x), a second pitch sensing mass (P2), to form a pair of pitch sensing masses, arranged in a symmetrical manner with respect to the first axis of symmetry (M1), externally with respect to the driving masses of the first pair (D1,D2) and of the second pair (D3,D4); wherein said first pitch sensing mass (P1) is elastically coupled also to the third driving mass (D3) through a respective coupling elastic element (20), having features corresponding to said coupling elastic element (20), and said second pitch sensing mass (P2) is elastically coupled to both the second driving mass (D2) and the fourth driving mass (D4) through respective coupling elastic elements (20), having features corresponding to said coupling elastic element (20);

a first and a second roll sensing masses (R1, R2) for sensing a roll angular velocity ($\Omega_R$) around the second horizontal axis (y), arranged symmetrically to each other on opposite sides of the first axis of symmetry (M1) and elastically connected to each other by a coupling elastic element (35), arranged centrally at the second axis of symmetry (M2), said roll sensing masses (R1, R2) being arranged internally to the driving masses of the first and second pairs (D1,D2, D3,D4), and wherein said first roll sensing mass (R1) is elastically coupled to the first and third driving masses (D1, D3), by respective elastic coupling elements (38), aligned along the first horizontal axis (x) and said second roll sensing mass (R2) is elastically coupled to the second and fourth driving masses (D2, D4), by respective elastic coupling elements (38), aligned along the first horizontal axis (x);

a first pair of yaw sensing masses (Y1,Y2) and a second pair of yaw sensing masses (Y3, Y4), for sensing a yaw angular velocity ($\Omega_Y$) around a vertical axis (z) orthogonal to said horizontal plane (xy), arranged externally and coupled to the driving masses of the first, respectively of the second pair (D1,D2, D3,D4) by respective coupling elastic elements (39),

wherein said pitch sensing masses (P1,P2), said roll sensing masses (R1,R2) and said yaw sensing masses (Y1,Y2, Y3,Y4) are driven by said driving masses (D1,D2, D3,D4), with a common driving mode, in order to perform the respective sensing movements for detection of the pitch, roll and yaw angular velocities ($\Omega_P$, $\Omega_R$, $\Omega_Y$).

7. The gyroscope according to claim 6, wherein the driving masses (D1,D2, D3,D4) are configured to perform a translation movement, in phase-opposition for each pair, along the second horizontal axis (y), the movement of the driving masses symmetrical to each other with respect to the first axis of symmetry (M1) also being in phase-opposition; and wherein the movement of the driving masses (D1,D2, D3,D4) is configured to cause: a rotation in phase-opposition of the roll sensing masses (R1, R2) in the horizontal plane (xy), around an axis parallel to the vertical axis (z) and passing through a respective center of the roll sensing masses (R1, R2); a translation movement in phase-opposition along the second horizontal axis (y) of the yaw sensing masses (Y1,Y2, Y3,Y4) in a manner integral with the driving masses (D1,D2, D3,D4); and also a rotation in phase-opposition of the pitch sensing masses (P1, P2), around an axis parallel to the vertical axis (z) and passing through a respective center of the pitch sensing masses (P1, P2).

8. The gyroscope according to claim 7, wherein the movements of the roll sensing masses (R1, R2), yaw sensing masses (Y1,Y2, Y3,Y4) and pitch sensing masses (P1, P2) due to the movement of the driving masses (D1,D2, D3,D4) occur entirely in the horizontal plane (xy).

9. The gyroscope according to claim 7 or 8, wherein the sensing movements of the roll sensing masses (R1, R2), yaw sensing masses (Y1,Y2, Y3,Y4) and pitch sensing masses (P1, P2) are independent of each other and do not have any mutual influences.

10. The gyroscope according to any of claims 7-9, wherein the driving masses (D1,D2, D3,D4) operate as decoupling elements between the roll sensing masses (R1, R2), the yaw sensing masses (Y1,Y2, Y3,Y4) and the pitch sensing masses (P1, P2), which are all connected to the sole driving masses (D1,D2, D3,D4), without any mutual connections.

**11.** The gyroscope according to any of claims 7-10, wherein the pitch sensing masses (P1,P2) are configured to perform, in the presence of the pitch angular velocity ($\Omega_P$) around the first horizontal axis (x) and due to the Coriolis force, respective rotation movements outside the horizontal plane (xy), in phase-opposition with each other, around the respective rotation axis (A) defined by a respective elastic arrangement (18) for coupling to a respective anchoring element (16).

**12.** The gyroscope according to any of claims 7-11, wherein the roll sensing masses (R1,R2) are configured to perform, in the presence of the roll angular velocity ($\Omega_R$) around the second horizontal axis (y) and due to the Coriolis force, a rotation in phase-opposition outside the horizontal plane (xy) around a respective rotation axis defined by corresponding elastic coupling elements (38).

**13.** The gyroscope according to any of claims 7-12, wherein the yaw sensing masses (Y1,Y2, Y3,Y4), in the presence of a yaw angular velocity ($\Omega_Y$) around the vertical axis (z) and due to the Coriolis force, are configured to carry out a translation movement in phase-opposition along the first horizontal axis (x).

**14.** The gyroscope according to any of claims 6-13, wherein each of the roll sensing masses (R1, R2) has a substantially rectangular shape in the horizontal plane (xy), elongated along the second horizontal axis (y) and centrally has a window, inside of which a respective roll anchor (36) is arranged, to which it is coupled by an elastic coupling arrangement defining a rotation axis for the sensing movement outside the horizontal plane (xy).

**15.** The gyroscope according to any of claims 6-14, wherein the yaw sensing masses of the first pair (Y1,Y2) and the yaw sensing masses of the second pair (Y3,Y4) are coupled to each other by respective elastic coupling structures (40), which extend centrally along the second horizontal axis (y), traversing the first axis of symmetry (M1); wherein each elastic coupling structure (40) defines a lever elastic element, of the central fulcrum type, hinged at a central anchor (42) and coupled at its ends to the respective yaw sensing masses of the first (Y1,Y2) or the second (Y3,Y4) pair.

FIG. 1A

FIG. 1B

FIG. 2A

FIG. 2B

FIG. 2C

FIG. 2D

FIG. 2E

FIG.3

FIG.4

FIG.5

FIG.6

FIG.7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 102024000017707 A
- EP 24177019